# EUROPEAN PATENT SPECIFICATION

(11) **EP 3 896 750 B1**
(45) Date of publication and mention of the grant of the patent: **20.11.2024**
(21) Application number: 19903299.6
(22) Date of filing: 27.12.2019
(51) Int. Cl.: H10K 39/10, H10K 39/12, H10K 85/50, H10K 30/10, H10K 30/85, H10K 30/86

(54) **PEROVSKITE FILM SOLAR MODULE AND MANUFACTURING METHOD THEREFOR**
SOLARMODUL MIT PEROWSKITSCHICHT UND VERFAHREN ZU SEINER HERSTELLUNG
MODULE SOLAIRE À COUCHES EN PÉROVSKITE ET SON PROCÉDÉ DE FABRICATION

(30) Priority: 28.12.2018 CN 201811620661
(43) Date of publication of application: 20.10.2021
(73) Proprietor: Wuxi Utmost Light Technology Co., Ltd., Wuxi, Jiangsu 214101 (CN)
(72) Inventor: SHAO, Jun, Wuxi, Jiangsu 214101 (CN)
(74) Representative: Habermann, Hruschka & Schnabel
(86) International application number: PCT/CN2019/129280
(87) International publication number: WO 2020/135739

(56) References cited:
- WO-A1-2016/186317
- CN-A- 106 229 327
- CN-A- 106 910 798
- CN-A- 107 210 368
- CN-A- 109 713 129
- US-A1- 2015 380 465
- US-A1- 2017 005 211

## Description

### TECHNICAL FIELD

The present disclosure relates to the field of photovoltaic devices, and in particular to a perovskite solar module and a manufacturing method therefor.

### BACKGROUND

Perovskite solar cells are currently a rapidly developing type of solar cells, which have the characteristics of high efficiency, low cost, and simple preparation, etc. In terms of structures, the perovskite solar cells are divided into planar structures and mesoporous structures, which mainly include a transparent electrode, an electron transport layer, a perovskite light-absorbing material, a hole transport layer, a counter electrode, etc. After absorbing light, the perovskite material generates photo-generated electrons and holes, which are transmitted to the electron transport layer and the hole transport layer, respectively, and are connected with an external circuit to form a loop to output electrical energy.

However, the existing perovskite solar cells still need to be improved.

US 2017/0005211 discloses the manufacture of a photovoltaic device comprising a photoactive perovskite.

WO2016/186,317 discloses a perovskite solar cell module in which solar cells including a material having a perovskite structure as an absorption layer.

### SUMMARY

In view of this, the present disclosure aims to provide a perovskite solar module and a preparation method thereof. The perovskite solar module is provided with a barrier layer, which can effectively solve problems such as shunt caused by direct contact between the photoactive layer and the electrode, and significantly improve the performance of the perovskite solar module.

In order to achieve the above objective, the technical solutions of the present disclosure is achieved as follows:

According to one aspect of the present disclosure, the present disclosure provides a perovskite solar module. According to an embodiment of the present disclosure, the perovskite solar module includes: a substrate; a transparent conductive oxide layer provided on at least a part of a surface of the substrate; an electron transport layer provided on at least a part of a surface of the transparent conductive oxide layer facing away from the substrate; a photoactive layer and a barrier layer that are formed on at least a part of a surface of the electron transport layer facing away from the transparent conductive oxide layer, where the barrier layer is provided in the photoactive layer; a hole transport layer provided on at least a part of a surface of the photoactive layer facing away from the electron transport layer; an electrode provided on at least a part of a surface of the hole transport layer and a surface of the barrier layer facing away from the photoactive layer, where the electrode has a protrusion penetrating through the hole transport layer, the barrier layer, and the electron transport layer to be connected to the transparent conductive oxide layer, the protrusion in a cross-sectional view being surrounded by and directly adjacent to the barrier layer, and the protrusion being separated apart from the photoactive layer by the barrier layer.

Compared with the related art, the perovskite solar module of the above embodiment of the present disclosure has at least the following advantages:

According to the perovskite solar module of the embodiment of the present disclosure, by providing a barrier layer in the photoactive layer, the barrier layer can be used to separate the photoactive layer from the electrode, and prevent photo-generated electrons or holes generated in the photoactive layer from flowing into the metal electrode, thus improving the performance of perovskite solar module. Also, the use of the barrier layer to isolate the photoactive layer from the electrode can also avoid the degradation and damage, etc. of the photoactive layer caused by chemical reactions that may occur during laser or physical scribing. In addition, the barrier layer can be formed simultaneously when the photoactive layer is formed, and the preparation method is simple.

Further, a first scribed region is formed in the transparent conductive oxide layer, and a part of the electron transport layer is provided in the first scribed region; or, a first scribed region is formed in the transparent conductive oxide layer and the electron transport layer, and a part of the barrier layer is provided in the first scribed region.

Further, the photoactive layer is formed of perovskite, and the barrier layer is formed of at least one of a halide-based material, an oxide-based material, a nitride-based material, and a carbide-based material.

Further, a band gap of the barrier layer is larger than a band gap of the photoactive layer.

Further, a band gap of the barrier layer is greater than or equal to 2.5eV, and a band gap of the photoactive layer ranges from 1.5eV to 1.8eV

Further, the perovskite solar module further includes: a second scribed region located in the electron transport layer, the barrier layer, and the hole transport layer, where the protrusion of the electrode is provided within the second scribed region.

According to another aspect of the present disclosure, the present disclosure provides a method for manufacturing the above-mentioned perovskite solar module. According to an embodiment of the present disclosure, the method includes steps of: (1) forming the transparent conductive oxide layer on the substrate, and forming the electron transport layer on the transparent conductive oxide layer after forming a first scribed region in the transparent conductive oxide layer by scribing; (2) forming the barrier layer and the photoactive layer on the electron transport layer; (3) forming the hole transport layer on the barrier layer and the photoactive layer; (4) forming a second scribed region in the electron transport layer, the barrier layer, and the hole transport layer by scribing and (5) providing the electrode on the hole transport layer, the protrusion of the electrode being provided within the second scribed region, where the protrusion in a cross-sectional view is surrounded by and directly adjacent to the barrier layer

According to the method for manufacturing the perovskite solar module of the embodiment of the present disclosure, after the transparent conductive oxide layer and the electron transport layer are formed, the material of the barrier layer and the material of the photoactive layer are further applied on the electron transport layer, and by making the material of the barrier layer and/or the material of the photoactive layer undergo selective phase change, the barrier layer and the photoactive layer are obtained. Subsequently, the hole transport layer is formed on the barrier layer and the photoactive layer, and the electrode is provided to obtain the perovskite solar module of the above-mentioned embodiment. Compared with the traditional manufacturing process of the perovskite solar module, this method does not need to increase the process steps too much, and the perovskite solar module of the above-mentioned embodiment can be obtained simply and efficiently by adopting this method.

Further, in the step (1), the electron transport layer is formed on the transparent conductive oxide layer after a first scribed region is formed in the transparent conductive oxide layer by scribing, and a part of the electron transport layer is formed within the first scribed region.

Further, in the step (1), it is also possible that after the transparent conductive oxide layer and the electron transport layer are sequentially formed on the substrate, the first scribed region is formed in the transparent conductive oxide layer and the electron transport layer by scribing, and a part of the barrier layer is formed within the first scribed region.

Further, the photoactive layer is formed of perovskite, and the barrier layer is formed of at least one of a halide-based material, an oxide-based material, a nitride-based material, and a carbide-based material.

Further, a band gap of the barrier layer is larger than a band gap of the photoactive layer.

Further, a band gap of the barrier layer is greater than or equal to 2.5eV, and a band gap of the photoactive layer ranges from 1.5eV to 1.8eV

Further, the method further includes: scribing the electrode and the hole transport layer (500) to obtain a third scribed region.

Further, the forming the barrier layer and the photoactive layer on the electron transport layer includes applying a barrier layer material and a photoactive layer material onto the electron transport layer by using a multi-notch extrusion coater to form the barrier layer and the photoactive layer.

According to another aspect of the present disclosure, the present disclosure provides a method for manufacturing the above-mentioned perovskite solar module. According to an embodiment of the present disclosure, the method includes steps of: (1) forming the transparent conductive oxide layer and the electron transport layer on the substrate, and forming a first scribed region in the transparent conductive oxide layer and the electron transport layer by scribing; (2) forming the barrier layer and the photoactive layer on the electron transport layer; (3) forming the hole transport layer on the barrier layer and the photoactive layer; (4) forming a second scribed region in the electron transport layer, the barrier layer, and the hole transport layer by scribing and (5) providing the electrode on the hole transport layer, the protrusion of the electrode being provided within the second scribed region, where the protrusion in a cross-sectional view is surrounded by and directly adjacent to the barrier layer

The additional aspects and advantages of the present disclosure will be partly given in the following description, and partly will become apparent from the following description, or be understood through the practice of the present disclosure.

The additional aspects and advantages of the present disclosure will be partly given in the following description, and part of them will become apparent from the following description, or be understood through the practice of the present disclosure.

### BRIEF DESCRIPTION OF DRAWINGS

The accompanying drawings are used to provide a further understanding of the present disclosure and constitute a part of the specification, and is used to explain the present disclosure together with the following specific embodiments, but does not constitute a limitation to the present disclosure. In the accompanying drawings:
FIG. 1 is a structural schematic diagram of a perovskite solar module according to an embodiment of the present disclosure;
FIG. 2 is a structural schematic diagram of a perovskite solar module according to another embodiment of the present disclosure;
FIG. 3 is a structural schematic diagram of a perovskite solar module according to still another embodiment of the present disclosure;
FIG. 4 is a structural schematic diagram of a perovskite solar module according to still another embodiment of the present disclosure;
FIG. 5 is a flow diagram showing a method for manufacturing a perovskite solar module according to an embodiment of the present disclosure;
FIG. 6 is a flow diagram showing a method for manufacturing a perovskite solar module according to another embodiment of the present disclosure;
FIG. 7 is a schematic diagram of a method for coating a barrier layer material and a photoactive layer material by using an extrusion coater according to an embodiment of the present disclosure;
FIG. 8 is a schematic diagram from another perspective of the method for coating a barrier layer material and a photoactive layer material by using an extrusion coater according to an embodiment of the present disclosure;
FIG. 9 is a flow diagram showing a method for forming a barrier layer and a photoactive layer according to an embodiment of the present disclosure; and
FIG. 10 is a flow diagram showing a method for forming a barrier layer and a photoactive layer according to another embodiment of the present disclosure.

Reference signs:
100: substrate; 200: transparent conductive oxide layer; 300: electron transport layer;
400: photoactive layer; 410: photoactive layer material;
500: hole transport layer; 600: electrode; 610: protrusion;
700: barrier layer;
710: halide-based material; 720: oxide-based material, nitride-based material or carbide-based material;
810: first scribed region; 820: second scribed region; 830: third scribed region;
900: extrusion coater; 910: first notch; 920: second notch.

### DESCRIPTION OF EMBODIMENTS

The embodiments of the present disclosure are described in detail below. Examples of the embodiments are shown in the accompanying drawings, in which the same or similar reference numerals indicate the same or similar elements or elements with the same or similar functions. The embodiments described below with reference to the accompanying drawings are exemplary, and are intended to explain the present disclosure, but should not be construed as limiting the present disclosure. Where specific techniques or conditions are not indicated in the examples, the procedures shall be carried out in accordance with the techniques or conditions described in the literature in the field or in accordance with the product specification. The reagents or instruments used without the indication of the manufacturers are all conventional products that can be purchased commercially.

In the description of the present disclosure, it should be understood that the orientation or position relationship indicated by the terms "center", "longitudinal", "transverse", "length", "width", "thickness", "upper", "lower", "front", "rear", "left", "right", "vertical", "horizontal", "top", "bottom", "inner", and "outer", etc. is based on the orientation or position relationship shown in the drawings, and is only for the convenience of describing the present disclosure and simplifying the description, rather than indicating or implying that the pointed device or element must have a specific orientation, or be constructed and operated in a specific orientation, and therefore cannot be understood as a limitation of the present disclosure.

In addition, the terms "first" and "second" are only used for descriptive purposes, and cannot be understood as indicating or implying relative importance or implicitly indicating the number of indicated technical features. Therefore, the features defined with "first" and "second" may explicitly or implicitly include at least one of the features. In the description of the present disclosure, "plurality" means at least two, such as two, three, etc., unless otherwise specifically defined.

In the present disclosure, unless otherwise clearly specified and limited, terms such as "install", "connect", "connect to", "fix" and the like should be understood in a broad sense. For example, it may be a fixed connection or a detachable connection or connection as one piece; mechanical connection or electrical connection; direct connection or indirect connection through an intermediate; internal communication of two components or the interaction relationship between two components, unless otherwise clearly limited. For those of ordinary skill in the art, the specific meaning of the above-mentioned terms in the present disclosure can be understood according to specific circumstances.

In the present disclosure, unless expressly stipulated and defined otherwise, the first feature "on" or "under" the second feature may mean that the first feature is in direct contact with the second feature, or the first and second features are in indirect contact through an intermediate. Moreover, the first feature "above" the second feature may mean that the first feature is directly above or obliquely above the second feature, or simply mean that the level of the first feature is higher than that of the second feature. The first feature "below" the second feature may mean that the first feature is directly below or obliquely below the second feature, or simply mean that the level of the first feature is smaller than that of the second feature.

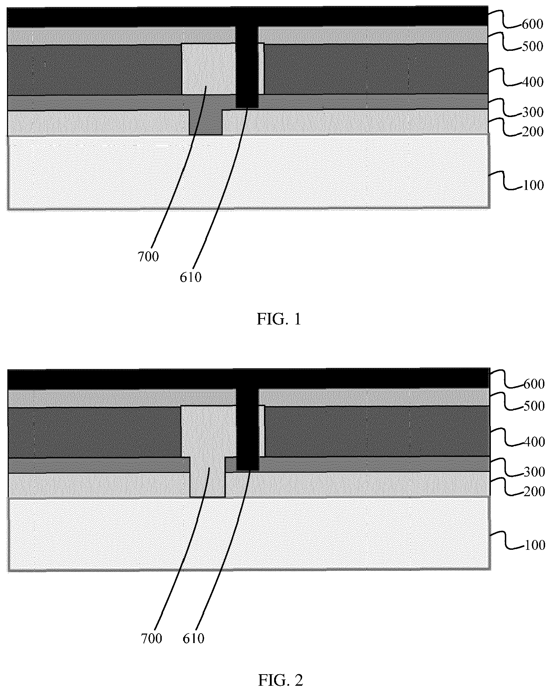

According to one aspect of the present disclosure, the present disclosure provides a perovskite solar module. According to an embodiment of the present disclosure, referring to FIGS. 1 and 2, the perovskite solar module includes: a substrate 100, a transparent conductive oxide layer 200, an electron transport layer 300, a photoactive layer 400, a hole transport layer 500, an electrode 600 and a barrier layer 700. The transparent conductive oxide layer 200 is provided on at least a part of a surface of the substrate 100; the electron transport layer 300 is provided on at least a part of a surface of the transparent conductive oxide layer 200 facing away from the substrate 100; the photoactive layer 400 is provided on at least a part of a surface of the electron transport layer 300 facing away from the transparent conductive oxide layer 200; the hole transport layer 500 is provided on at least a part of a surface of the photoactive layer 400 facing away from the electron transport layer 300; the electrode 600 is provided on at least a part of a surface of the hole transport layer 500 facing away from the photoactive layer 400; the electrode 600 has a protrusion 610 penetrating through the hole transport layer 500, the photoactive layer 400, and the electron transport layer 300 to be connected to the transparent conductive oxide layer 200; and the barrier layer 700 is provided in the photoactive layer 400 and separates the photoactive layer 400 from the protrusion 610 of the electrode 600.

Hereinafter, the perovskite solar module according to the embodiment of the present disclosure will be further described in detail with reference to FIGS. 1 to 4.

According to an embodiment of the present disclosure, in a manufacturing method of the perovskite solar module, it is possible that the transparent conductive oxide layer 200 is formed on the substrate 100 first, and then the transparent conductive oxide layer 200 is scribed to obtain a first scribed region (Scheme I); and it is also possible that the transparent conductive oxide layer 200 and the electron transport layer 300 are formed on the substrate 100 first, and then the transparent conductive oxide layer 200 and the electron transport layer 300 are scribed to obtain a first scribed region (Scheme II). Therefore, in the above Scheme I, the first scribed region is formed in the transparent conductive oxide layer 200, and then, when the electron transport layer 300 is further formed on the transparent conductive oxide layer 200, a part of the electron transport layer 300 will be formed in the first scribed region, as shown in FIG. 1. In the above Scheme II, the transparent conductive oxide layer 200 and the electron transport layer 300 are both formed with the first scribed region, and then, when the barrier layer 700 is further formed on the electron transport layer, a part of the barrier layer 700 will be formed within the first scribed region, as shown in FIG. 2.

According to an embodiment of the present disclosure, the above-mentioned photoactive layer 400 is a perovskite layer, for example, it can be obtained by forming a perovskite crystal form of CH₃NH₃PbIₓ, CH₃NH₃PbBrₓ, etc.; the above-mentioned barrier layer 700 is formed of at least one of a halide-based material, an oxide-based material, a nitride-based material, and a carbide-based material. The halide-based material may be, for example, chloride (such as lead chloride), bromide (such as cyanogen bromide), or iodide (such as lead iodide), and the oxide-based material may be, for example, Al₂O₃, SiO₂, and the like. Preferably, the halide-based material uses bromide or iodide, so that the barrier layer 700 formed of bromide or iodide can passivate the edge of the photoactive layer 400 (perovskite layer) to a certain extent, thereby further improving the stability of the photoactive layer 400.

According to an embodiment of the present disclosure, a band gap of the barrier layer 700 is greater than a band gap of the photoactive layer 400. Therefore, the barrier layer 700 can effectively block the photo-generated electrons and holes in the photoactive layer 400 from flowing into the electrode, thereby improving the overall reliability of the solar module.

According to a preferred embodiment of the present disclosure, the band gap of the barrier layer 700 is greater than or equal to 2.5eV, and the band gap of the photoactive layer 400 ranges from 1.5eV to 1.8eV Thus, the barrier layer 700 has a better blocking effect on the photo-generated electrons and holes generated in the photoactive layer 400.

According to an embodiment of the present disclosure, the perovskite solar module may further include: a second scribed region, which is obtained by scribing the electron transport layer 300, the photoactive layer 400, the hole transport layer 500, and the barrier layer 700, and thus is located in the electron transport layer 300, the photoactive layer 400, the hole transport layer 500 and the barrier layer 700, and the protrusion 610 of the electrode 600 is provided within the second scribed region.

In addition, it should be noted that the perovskite solar module of the present disclosure does not specifically limit the specific types or materials of the substrate, the transparent conductive oxide layer, the electron transport layer, the hole transport layer, and the electrode., which can be obained by those skilled in the art according to conventional choices. For example, the substrate may be a glass substrate; the transparent conductive oxide layer may be formed of at least one of aluminum-doped zinc oxide (AZO), boron-doped zinc oxide (BZO), gallium-doped zinc oxide (GZO), gallium and aluminum-doped zinc oxide (GAZO), and fluorine-doped tin oxide (FTO), tin-doped indium oxide (ITO), tungsten-doped indium oxide (IWO), and titanium-doped indium oxide (ITIO); the electron transport layer may be formed of a fullerene derivative PCBM; the hole transport layer can be formed of poly(3,4-ethylenedioxythiophene)-polystyrene sulfonic acid (PEDOT:PSS); and the electrode may be a metal electrode (such as Ag electrode, Cu electrode, Au electrode, etc.), an oxide electrode, a carbon material electrode or a composite electrode. Since the barrier layer can separate the photoactive layer apart from the electrode, the material of the electrode in the solar module of the present disclosure has a larger selection range.

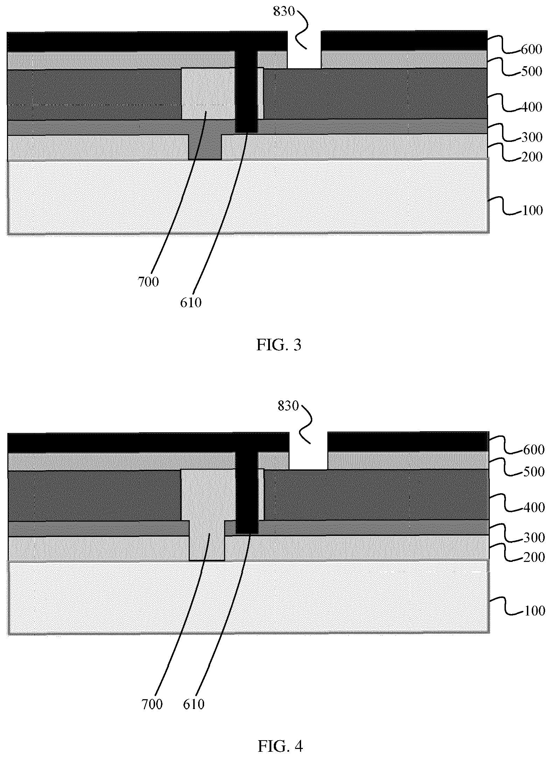

According to some embodiments of the present disclosure, the perovskite solar module of the present disclosure may further have conventional structures such as encapsulation and backsheet, which will not be repeated here. In order to facilitate the packaging of the perovskite solar module or the setting of the backsheet, the electrode and the hole transport layer may be further scribed to obtain a third scribed region 830, as shown in FIGS. 3 and 4.

According to another aspect of the present disclosure, the present disclosure provides a method for manufacturing the perovskite solar module of the above-mentioned embodiment. According to an embodiment of the present disclosure, the method includes steps of: (1) forming the transparent conductive oxide layer on the substrate, and forming the electron transport layer on the transparent conductive oxide layer after forming a first scribed region in the transparent conductive oxide layer by scribing; (2) forming the barrier layer and the photoactive layer on the electron transport layer; (3) forming the hole transport layer on the barrier layer and the photoactive layer; and (4) providing the electrode on the hole transport layer.

According to the method for manufacturing the perovskite solar module of the embodiment of the present disclosure, after the transparent conductive oxide layer and the electron transport layer are formed, the barrier layer material and the photoactive layer material are further applied on the electron transport layer, and by making the barrier layer material and/or the photoactive layer material undergo selective phase change, the barrier layer and the photoactive layer are obtained. Subsequently, the hole transport layer is formed on the barrier layer and the photoactive layer, and the electrode is provided to obtain the perovskite solar module of the above-mentioned embodiment. Compared with the traditional manufacturing process of the perovskite solar module, this method does not need to increase the process steps too much, and the perovskite solar module of the above-mentioned embodiment can be obtained simply and efficiently by adopting this method.

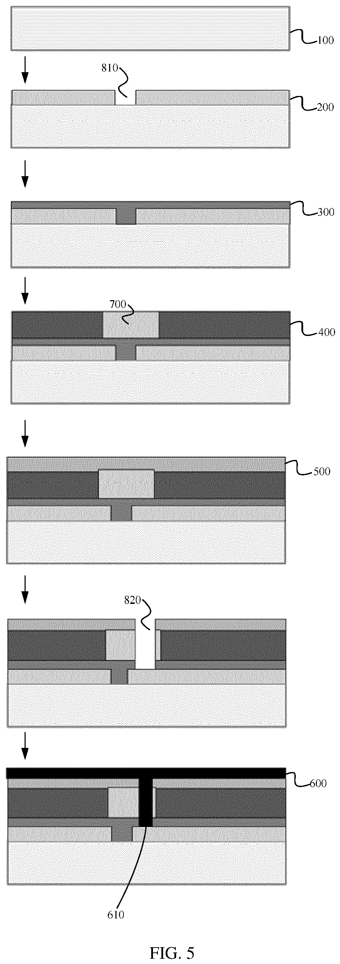

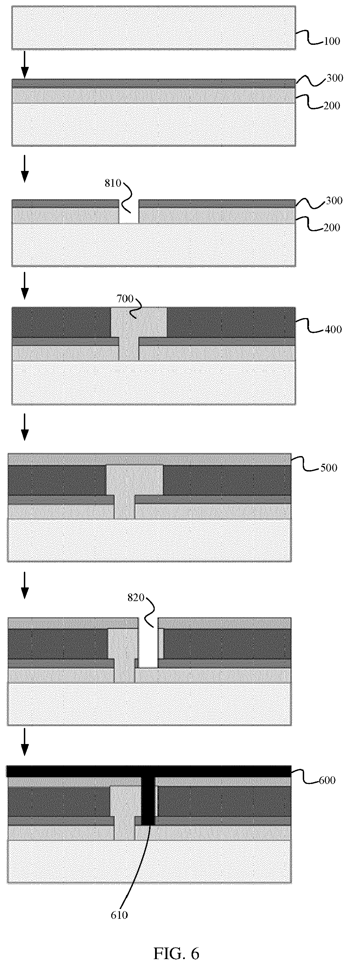

According to an embodiment of the present disclosure, in the step (1), it is also possible that after the transparent conductive oxide layer and the electron transport layer are sequentially formed on the substrate, the first scribed region is formed in the transparent conductive oxide layer and the electron transport layer by scribing. Specifically, in the preparation method of the perovskite solar module, either one of the following two scheme is possible: (1) the transparent conductive oxide layer 200 is formed on the substrate 100 first, and then the transparent conductive oxide layer 200 is scribed to obtain the first scribed region 810 ( as shown in FIG. 5); (2) the transparent conductive oxide layer 200 and the electron transport layer 300 are formed on the substrate 100 first, and then the transparent conductive oxide layer 200 and the electron transport layer 300 are scribed to obtain the first scribed region 810 (as shown in FIG. 6).

The method for manufacturing the perovskite solar module according to the embodiment of the present disclosure will be described in detail below with reference to FIG. 5 and FIG. 6, respectively.

Referring to FIG. 5, according to an embodiment of the present disclosure, a transparent conductive oxide layer 200 may be formed on the substrate 100 first, and then, after a first scribed region 810 is formed on the transparent conductive oxide layer 200 by laser or physical scribing, an electron transport layer 300 is further formed on the transparent conductive oxide layer 200, and thus, a part of the electron transport layer 300 is formed within the first scribed region 810.

Referring to FIG. 6, according to an embodiment of the present disclosure, a transparent conductive oxide layer 200 and an electron transport layer 300 can be sequentially formed on the substrate 100, and then, a first scribed region 810 is formed on the transparent conductive oxide layer 200 and the electron transport layer 300 by laser or physical scribing. Therefore, when a photoactive layer 400 and a barrier layer 700 are subsequently formed, a part of the barrier layer 700 will be formed within the first scribed region 810.

It should be noted that the method of forming the transparent conductive oxide layer 200 and the electron transport layer 300 is not particularly limited, and can be selected by those skilled in the art according to actual needs. For example, a conventional transparent conductive oxide layer material and a conventional electron transport layer material may be respectively used to prepare a solution or a slurry, and the transparent conductive oxide layer 200 and the electron transport layer 300 may be formed sequentially by a coating method, or by chemical vapor deposition, etc.

Further, referring to FIGS. 5 and 6, a photoactive layer 400 and a barrier layer 700 are formed on the electron transport layer 300. The method of forming the photoactive layer 400 and the barrier layer 700 is not particularly limited, and can be selected by those skilled in the art according to actual needs. In some embodiments, in order to form the perovskite photoactive layer, a conventional material suitable for forming the perovskite layer and a barrier layer can be used to respectively prepare a solution or slurry, and the photoactive layer and the barrier layer are formed on the electron transport layer by a coating method. According to some embodiments of the present disclosure, after the material of the perovskite layer is coated, the material used to form the perovskite layer is transformed into the perovskite crystal structure by using an appropriate treatment method (for example, heat treatment).

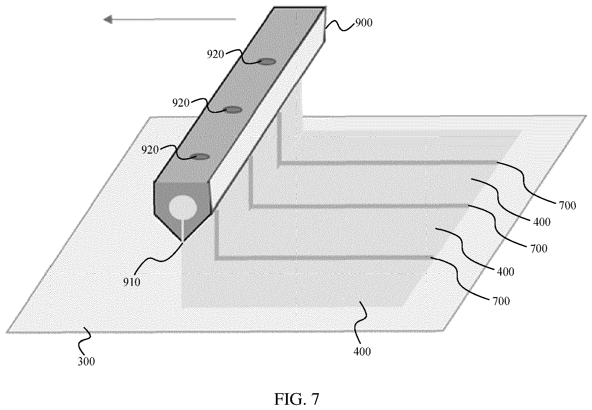

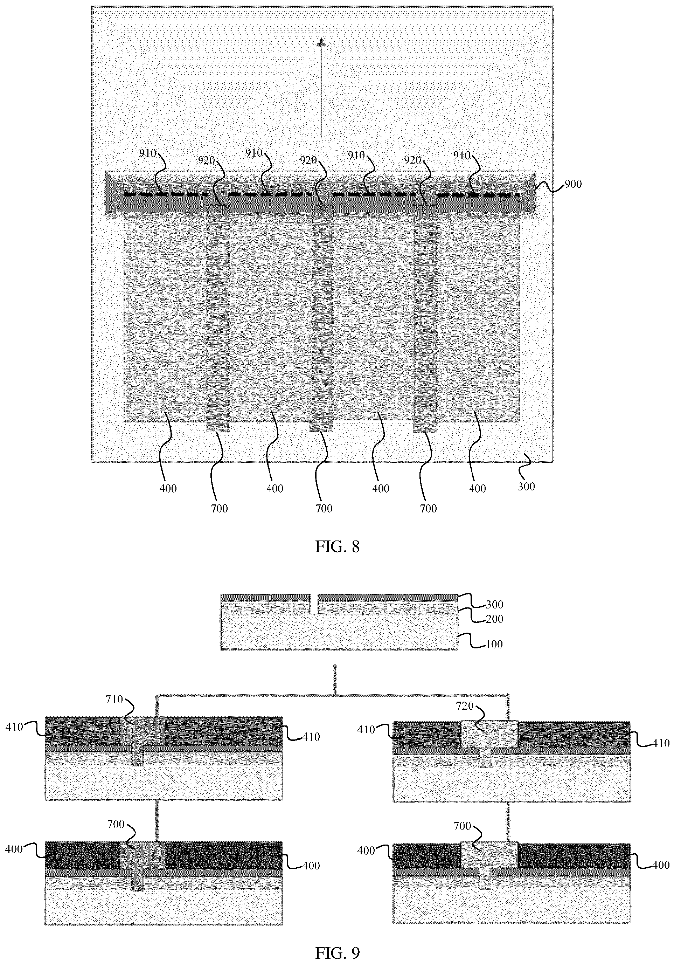

According to a specific example of the present disclosure, referring to FIGS. 7 and 8, a multi-notch extrusion coater 900 may be used to apply the photoactive layer material and the barrier layer material simultaneously onto the electron transport layer 300. The extrusion coater 900 includes a plurality of first notches 910 and a plurality of second notches 920. The first notches 910 and the second notches 920 are arranged at intervals in sequence, and are suitable for outputting different materials, thereby achieving the photoactive layer 400 and the barrier layer 700 simultaneously on the electron transport layer 300.

Further, referring to FIGS. 5 and 6, a hole transport layer 500 is formed on the photoactive layer 400 and the barrier layer 700. The method of forming the hole transport layer 500 is not particularly limited, and can be selected by those skilled in the art according to actual needs. For example, a conventional hole transport layer material can be used to prepare a solution or slurry, and the hole transport layer 500 can be formed sequentially by a coating method, or by chemical vapor deposition or other methods.

Further, referring to FIGS. 5 and 6, a second scribed region 820 is formed in the electron transport layer 300, the hole transport layer 500, and the barrier layer 700 by scribing, and then an electrode 600 is provided on the hole transport layer 500, with the protrusion 610 of the electrode 600 being provided within the second scribed region 820. Since the solar module of the present disclosure is provided with the barrier layer, in this step, the barrier layer 700 can be scribed without scribing the photoactive layer 400, which can meet the requirements for setting the electrode 600, thereby further improving the reliability of the solar module.

Further, conventional processing such as packaging or setting of a backsheet may also be performed on the solar module, which will not be repeated here. In order to facilitate the packaging or the setting of the backsheet of the solar module, the electrode 600 and the hole transport layer 500 may be further scribed to obtain a third scribed region 830, as shown in FIGS. 3 and 4.

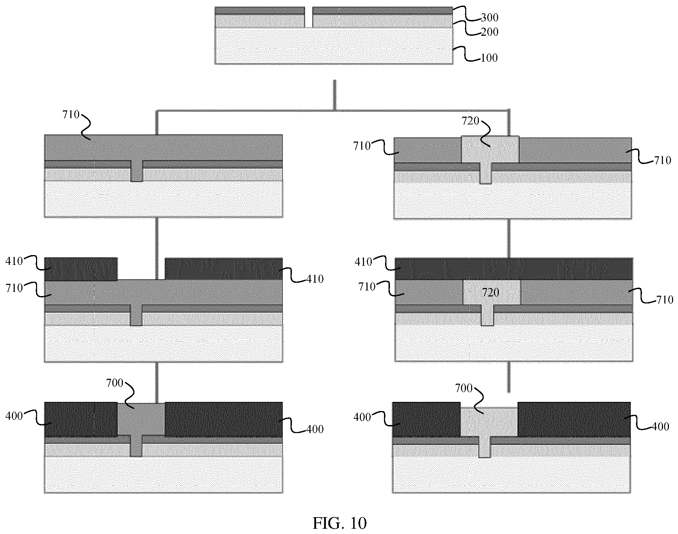

In addition, according to an embodiment of the present disclosure, referring to FIGS. 9 and 10, the present disclosure also proposes a method for forming the barrier layer 700 and the photoactive layer 400 through "selective phase change". In FIGS. 9 and 10, 710 represents a halide-based material (such as lead chloride and/or lead bromide), 720 represents an oxide-based material, a nitride-based material, or a carbide-based material, and 410 represents a material for forming the perovskite photoactive layer, wherein the material for forming the perovskite photoactive layer may include methylamine iodide (MAI) and halide.

Referring to FIG. 9, the barrier layer 700 and the photoactive layer 400 may be formed simultaneously. Specifically, using the multi-slot extrusion coater as described above, the barrier layer material and the photoactive layer material are respectively extruded and coated through different notches. According to a specific example of the present disclosure, further, the perovskite photoactive layer can be obtained by heat-treating the material for forming the perovskite photoactive layer.

Referring to FIG. 10, the barrier layer 700 and the photoactive layer 400 may be formed in separate steps. Specifically, when a halide-based material is used as a barrier layer material, a layer of barrier layer material 710 can be coated on the electron transport layer 300 first, and then the multi-slot extrusion coater as described above is used to coat the material 410 for forming the perovskite photoactive layer on the barrier layer material 710 at intervals, and further through heat treatment, the material 410 for forming a perovskite photoactive layer can form the perovskite photoactive layer with the barrier layer 710 located there under. Since the material 410 for forming the perovskite photoactive layer is coated at intervals, the part of the barrier layer material that is not covered with 410 will form the barrier layer. When the oxide-based material, the nitride-based material or the carbide-based material is used as the barrier layer material, the multi-notch extrusion coater as described above can be used to respectively extrude and coat the barrier layer material and the halide in the perovskite photoactive layer material through different notches, and then other material for forming the perovskite photoactive layer is coated on the barrier layer material and the halide material. Further, through heat treatment, the other material for forming the perovskite photoactive layer and the halide material form the perovskite photoactive layer without reacting with the barrier layer material 720, thereby obtaining the barrier layer and the photoactive layer.

In addition, the materials for forming the perovskite photoactive layer can also use formamidine iodide (FAI), Cs or Rb-containing MAI, or Cs or Rb-containing FAI instead of MAI, or other halides instead of lead iodide and lead bromide. In the method shown in FIG. 10, KI or HI can also be added to the material for forming the perovskite photoactive layer, so that I can be used to fill the possible defects of the perovskite crystal form, thereby further improving the selective phase change effect of the photoactive layer material and the performance of the perovskite solar module.

According to a specific example of the present disclosure, in the method shown in FIG. 9, 710 indicates lead bromide, 720 indicates alumina; and 410 indicates a mixed material of MAI, lead iodide and lead bromide. In the method shown in FIG. 10, 710 indicates lead bromide, 720 indicates alumina; 410 indicates a mixed material of MAI, KI or HI, lead iodide and lead bromide.

In the description of this specification, descriptions with reference to the terms "an embodiment", "some embodiments", "examples", "specific examples", or "some examples" etc. mean that specific features, structure, materials or characteristics described in conjunction with the embodiment or example are included in at least one embodiment or example of the present disclosure. In this specification, the schematic representations of the above terms do not necessarily refer to the same embodiment or example. Moreover, the described specific features, structures, materials or characteristics may be combined in any one or more embodiments or examples in a suitable manner. In addition, those skilled in the art can combine the different embodiments or examples and the features of the different embodiments or examples described in this specification without contradicting each other.

## Claims

1. A perovskite solar module, comprising:
a substrate (100);
a transparent conductive oxide layer (200) provided on at least a part of a surface of the substrate;
an electron transport layer (300) provided on at least a part of a surface of the transparent conductive oxide layer facing away from the substrate;
a photoactive layer (400) and a barrier layer (700) that are formed on at least a part of a surface of the electron transport layer facing away from the transparent conductive oxide layer, wherein the barrier layer is provided in the photoactive layer;
a hole transport layer (500) provided on at least a part of a surface of the photoactive layer and a surface of the barrier layer facing away from the electron transport layer; and
an electrode (600) provided on at least a part of a surface of the hole transport layer facing away from the photoactive layer,
**characterized in that** the electrode has a protrusion (610) penetrating through the hole transport layer, the barrier layer, and the electron transport layer to be connected to the transparent conductive oxide layer, the protrusion (610) in a cross-sectional view being surrounded by and directly adjacent to the barrier layer (700), and the protrusion being separated apart from the photoactive layer by the barrier layer.

2. The perovskite solar module according to claim 1, wherein a first scribed region (810) is formed in the transparent conductive oxide layer (200), and a portion of the electron transport layer (300) is provided within the first scribed region; or
a first scribed region (810) is formed in the transparent conductive oxide layer (200) and the electron transport layer (300), and a portion of the barrier layer (700) is provided within the first scribed region.

3. The perovskite solar module according to claim 1, wherein the photoactive layer (400) is formed of perovskite, and the barrier layer (700) is formed of at least one of a halide-based material, an oxide-based material, a nitride-based material, and a carbide-based material.

4. The perovskite solar module according to claim 3, wherein a band gap of the barrier layer (700) is larger than a band gap of the photoactive layer (400).

5. The perovskite solar module according to claim 3, wherein a band gap of the barrier layer (700) is greater than or equal to 2.5eV, and a band gap of the photoactive layer (400) ranges from 1.5eV to 1.8eV

6. The perovskite solar module according to any one of claims 1 to 5, further comprising:
a second scribed region (820) located in the electron transport layer (300), the barrier layer (700), and the hole transport layer (500), wherein the protrusion (610) of the electrode is provided within the second scribed region.

7. A method for manufacturing the perovskite solar module according to claim 1, the method comprising steps of:
(1) forming the transparent conductive oxide layer (200) on the substrate, and forming the electron transport layer (300) on the transparent conductive oxide layer after forming a first scribed region (810) in the transparent conductive oxide layer by scribing;
(2) forming the barrier layer (700) and the photoactive layer (400) on the electron transport layer;
(3) forming the hole transport layer (500) on the barrier layer and the photoactive layer;
(4) forming a second scribed region (820) in the electron transport layer, the barrier layer, and the hole transport layer by scribing, and **characterized by**
(5) providing the electrode on the hole transport layer, the protrusion (610) of the electrode being provided within the second scribed region,
wherein the protrusion (610) in a cross-sectional view is surrounded by and directly adjacent to the barrier layer (700).

8. The method according to claim 7, wherein, in the step (1), a part of the electron transport layer is formed within the first scribed region.

9. The method according to claim 7, wherein, in the step (1), a part of the barrier layer (700) is formed within the first scribed region.

10. The method according to claim 7, wherein the photoactive layer (400) is formed of perovskite, and the barrier layer (700) is formed of at least one of a halide-based material, an oxide-based material, a nitride-based material, and a carbide-based material.

11. The method according to claim 10, wherein a band gap of the barrier layer (700) is larger than a band gap of the photoactive layer (400).

12. The method according to claim 10, wherein a band gap of the barrier layer (700) is greater than or equal to 2.5eV, and a band gap of the photoactive layer (400) ranges from 1.5eV to 1.8eV

13. The method according to claim 7, further comprising: scribing the electrode (600) and the hole transport layer (500) to obtain a third scribed region (830).

14. The method according to claim 7, wherein said simultaneously forming the barrier layer (700) and the photoactive layer (400) on the electron transport layer (300) comprises applying a barrier layer material and a photoactive layer material simultaneously onto the electron transport layer by using a multi-notch extrusion coater to simultaneously form the barrier layer and the photoactive layer.

## Patentansprüche

1. Perowskit-Solarmodul, aufweisend:
ein Substrat (100);
eine transparente leitende Oxidschicht (200), die auf mindestens einem Teil einer Oberfläche des Substrats vorgesehen ist;
eine Elektronentransportschicht (300), die auf mindestens einem Teil einer Oberfläche der transparenten leitenden Oxidschicht (200) vorgesehen ist, die vom Substrat abgewandt ist;
eine photoaktive Schicht (400) und eine Sperrschicht (700), die auf mindestens einem Teil einer Oberfläche der Elektronentransportschicht, die von der transparenten leitenden Oxidschicht abgewandt ist, ausgebildet sind, wobei die Sperrschicht in der photoaktiven Schicht vorgesehen ist;
eine Lochtransportschicht (500), die auf mindestens einem Teil einer Oberfläche der photoaktiven Schicht und einer von der Elektronentransportschicht abgewandten Oberfläche der Sperrschicht vorgesehen ist; und
eine Elektrode (600), die auf mindestens einem Teil einer von der photoaktiven Schicht abgewandten Oberfläche der Lochtransportschicht vorgesehen ist,
**dadurch gekennzeichnet, dass**
die Elektrode einen Vorsprung (610) aufweist, der durch die Lochtransportschicht, die Sperrschicht und die Elektronentransportschicht hindurchgeht, um mit der transparenten leitenden Oxidschicht verbunden zu werden, wobei der Vorsprung (610) in einer Querschnittsansicht von der Sperrschicht (700) umgeben ist und direkt an diese angrenzt, und wobei der Vorsprung durch die Sperrschicht von der photoaktiven Schicht getrennt ist.

2. Perowskit-Solarmodul nach Anspruch 1, bei dem ein erster geritzter Bereich (810) in der transparenten leitfähigen Oxidschicht (200) ausgebildet ist und ein Abschnitt der Elektronentransportschicht (300) innerhalb des ersten geritzten Bereichs vorgesehen ist; oder
ein erster geritzter Bereich (810) in der transparenten leitenden Oxidschicht (200) und der Elektronentransportschicht (300) ausgebildet ist und ein Abschnitt der Sperrschicht (700) innerhalb des ersten geritzten Bereichs vorgesehen ist.

3. Perowskit-Solarmodul nach Anspruch 1, bei dem die photoaktive Schicht (400) aus Perowskit gebildet ist, und die Sperrschicht (700) aus mindestens einem Material auf Halogenidbasis, einem Material auf Oxidbasis, einem Material auf Nitridbasis und einem Material auf Karbidbasis gebildet ist.

4. Perowskit-Solarmodul nach Anspruch 3, bei dem ein Bandabstand der Sperrschicht (700) größer ist als ein Bandabstand der photoaktiven Schicht (400).

5. Perowskit-Solarmodul nach Anspruch 3, bei dem ein Bandabstand der Sperrschicht (700) größer oder gleich 2,5 eV ist und ein Bandabstand der photoaktiven Schicht (400) im Bereich von 1,5 eV bis 1,8 eV liegt.

6. Perowskit-Solarmodul nach einem der Ansprüche 1 bis 5, des Weiteren aufweisend:
einen zweiten geritzten Bereich (820), der sich in der Elektronentransportschicht (300), der Sperrschicht (700) und der Lochtransportschicht (500) befindet, wobei der Vorsprung (610) der Elektrode innerhalb des zweiten geritzten Bereichs vorgesehen ist.

7. Verfahren zur Herstellung eines Perowskit-Solarmoduls nach Anspruch 1, wobei das Verfahren die Schritte aufweist:
(1) Ausbilden der transparenten leitfähigen Oxidschicht (200) auf dem Substrat und Ausbilden der Elektronentransportschicht (300) auf der transparenten leitfähigen Oxidschicht nach Ausbilden eines ersten geritzten Bereichs (810) in der transparenten leitfähigen Oxidschicht durch Ritzen;
(2) Ausbilden der Sperrschicht (700) und der photoaktiven Schicht (400) auf der Elektronentransportschicht;
(3) Ausbildern der Lochtransportschicht (500) auf der Sperrschicht und der photoaktiven Schicht;
(4) Ausbilden eines zweiten geritzten Bereichs (820) in der Elektronentransportschicht, der Sperrschicht und der Lochtransportschicht durch Ritzen, und
**gekennzeichnet durch**
(5) Anbringen der Elektrode auf der Lochtransportschicht, wobei der Vorsprung (610) der Elektrode innerhalb des zweiten geritzten Bereichs vorgesehen ist,
wobei der Vorsprung (610) in einer Querschnittsansicht in einer Querschnittsansicht von der Sperrschicht (700) umgeben ist und direkt an diese angrenzt.

8. Verfahren nach Anspruch 7, bei dem in Schritt (1) ein Teil der Elektronentransportschicht innerhalb des ersten geritzten Bereichs ausgebildet wird.

9. Verfahren nach Anspruch 7, bei dem im Schritt (1) ein Teil der Sperrschicht (700) innerhalb des ersten geritzten Bereichs ausgebildet wird.

10. Verfahren nach Anspruch 7, bei dem die photoaktive Schicht (400) aus Perowskit gebildet ist, und die Sperrschicht (700) aus mindestens einem Material auf Halogenidbasis, einem Material auf Oxidbasis, einem Material auf Nitridbasis und einem Material auf Karbidbasis gebildet ist.

11. Verfahren nach Anspruch 10, bei dem ein Bandabstand der Sperrschicht (700) größer ist als ein Bandabstand der photoaktiven Schicht (400).

12. Verfahren nach Anspruch 10, bei dem ein Bandabstand der Sperrschicht (700) größer oder gleich 2,5 eV ist und ein Bandabstand der photoaktiven Schicht (400) im Bereich von 1,5 eV bis 1,8 eV liegt.

13. Verfahren nach Anspruch 7, des Weiteren aufweisend:
Ritzen der Elektrode (600) und der Lochtransportschicht (500), um einen dritten geritzten Bereich (830) zu erhalten.

14. Verfahren nach Anspruch 7, bei dem das gleichzeitige Ausbilden der Sperrschicht (700) und der photoaktiven Schicht (400) auf der Elektronentransportschicht (300) das gleichzeitige Aufbringen eines Sperrschichtmaterials und eines photoaktiven Schichtmaterials auf die Elektronentransportschicht unter Verwendung eines Mehrfachkerben-Extrusionsbeschichters zum gleichzeitigen Ausbilden der Sperrschicht und der photoaktiven Schicht umfasst.

## Revendications

1. Module solaire en pérovskite, comprenant:
un substrat (100);
une couche d'oxyde conductrice transparente (200) prévue sur au moins une partie d'une surface du substrat;
une couche de transport d'électrons (300) prévue sur au moins une partie d'une surface de la couche d'oxyde conductrice transparente (200) qui est opposée au substrat;
une couche photoactive (400) et une couche barrière (700) formées sur au moins une partie d'une surface de la couche de transport d'électrons qui est opposée à la couche d'oxyde conductrice transparente, la couche barrière étant prévue dans la couche photoactive;
une couche de transport de trous (500) prévue sur au moins une partie d'une surface de la couche photoactive et une surface de la couche barrière opposée à la couche de transport d'électrons; et
une électrode (600) prévue sur au moins une partie d'une surface de la couche de transport de trous qui est opposée de la couche photoactive,
**caractérisé en ce que**
l'électrode comprend une saillie (610) qui passe à travers la couche de transport de trous, la couche barrière et la couche de transport d'électrons pour être liée à la couche d'oxyde conductrice transparente, dans laquelle la saillie (610) est entourée par la couche barrière (700) et directement adjacente à celle-ci dans une vue en coupe transversale, et dans laquelle la saillie est séparée de la couche photoactive par la couche barrière.

2. Module solaire en pérovskite selon la revendication 1, dans lequel une première zone incisée (810) est formée dans la couche d'oxyde conductrice transparente (200) et une partie de la couche de transport d'électrons (300) est prévue à l'intérieur de la première zone incisée; ou
une première zone incisée (810) est formée dans la couche d'oxyde conductrice transparente (200) et la couche de transport d'électrons (300), et une partie de la couche barrière (700) est prévue à l'intérieur de la première zone incisée.

3. Module solaire en pérovskite selon la revendication 1, dans lequel la couche photoactive (400) est formée de pérovskite, et la couche barrière (700) est formée d'au moins un matériau à base d'halogénure, un matériau à base d'oxyde, un matériau à base de nitrure et un matériau à base de carbure.

4. Module solaire en pérovskite selon la revendication 3, dans lequel une bande interdite de la couche barrière (700) est supérieure à une bande interdite de la couche photoactive (400) .

5. Module solaire en pérovskite selon la revendication 3, dans lequel une bande interdite de la couche barrière (700) est supérieure ou égale à 2,5 eV et une bande interdite de la couche photoactive (400) est comprise dans la plage de 1,5 eV à 1,8 eV.

6. Module solaire en pérovskite selon l'une quelconque des revendications 1 à 5, comprenant en outre:
une seconde zone incisée (820) située dans la couche de transport d'électrons (300), la couche barrière (700) et la couche de transport de trous (500), la saillie (610) de l'électrode étant prévue à l'intérieur de la seconde zone incisée.

7. Procédé de fabrication d'un module solaire en pérovskite selon la revendication 1, ledit procédé comprenant les étapes consistant à:
(1) former la couche d'oxyde conductrice transparente (200) sur le substrat et former la couche de transport d'électrons (300) sur la couche d'oxyde conducteur transparent après avoir formé une première zone incisée (810) dans la couche d'oxyde conductrice transparente par incision;
(2) former la couche barrière (700) et la couche photoactive (400) sur la couche de transport d'électrons;
(3) former la couche de transport de trous (500) sur la couche barrière et la couche photoactive;
(4) former une seconde zone incisée (820) dans la couche de transport d'électrons, la couche barrière et la couche de transport de trous par incision, et
**caractérisé par**
(5) monter l'électrode sur la couche de transport de trous, la saillie (610) de l'électrode étant prévue à l'intérieur de la seconde zone incisée,
dans lequel la saillie (610) est entourée par la couche barrière (700) et est directement adjacente à celle-ci dans une vue en coupe transversale.

8. Procédé selon la revendication 7, dans lequel, à l'étape (1), une partie de la couche de transport d'électrons est formée à l'intérieur de la première zone incisée.

9. Procédé selon la revendication 7, dans lequel, à l'étape (1), une partie de la couche barrière (700) est formée à l'intérieur de la première zone incisée.

10. Procédé selon la revendication 7, dans lequel la couche photoactive (400) est formée de pérovskite, et la couche barrière (700) est formée d'au moins un matériau à base d'halogénure, un matériau à base d'oxyde, un matériau à base de nitrure et un matériau à base de carbure.

11. Procédé selon la revendication 10, dans lequel une bande interdite de la couche barrière (700) est supérieure à une bande interdite de la couche photoactive (400).

12. Procédé selon la revendication 10, dans lequel une bande interdite de la couche barrière (700) est supérieure ou égale à 2,5 eV et une bande interdite de la couche photoactive (400) se situe dans la plage de 1,5 eV à 1,8 eV.

13. Procédé selon la revendication 7, comprenant en outre:
inciser de l'électrode (600) et de la couche de transport de trous (500) afin d'obtenir une troisième zone incisée (830) .

14. Procédé selon la revendication 7, dans lequel la formation simultanée de la couche barrière (700) et de la couche photoactive (400) sur la couche de transport d'électrons (300) comprend l'application simultanée d'un matériau de couche barrière et d'un matériau de couche photoactive sur la couche de transport d'électrons en utilisant une coucheuse par extrusion à encoches multiples pour former simultanément la couche barrière et la couche photoactive.
